## Europäisches Patentamt

## European Patent Office

## Office européen des brevets

(19)

(11) Numéro de publication: **0 048 642**
**B1**

(12) # FASCICULE DE BREVET EUROPEEN

(45) Date de publication du fascicule du brevet:
21.09.83

(51) Int. Cl.³: **H 01 L 41/22**

(21) Numéro de dépôt: **81401320.7**

(22) Date de dépôt: **19.08.81**

(54) **Procédé de fabrication de films polymères piézoélectriques.**

(30) Priorité: **19.09.80 FR 8020213**

(43) Date de publication de la demande:
**31.03.82 Bulletin 82/13**

(45) Mention de la délivrance du brevet:
**21.09.83 Bulletin 83/38**

(84) Etats contractants désignés:
**DE GB NL**

(56) Documents cités:
**FR-A-2 349 961**
**GB-A-1 135 737**

(73) Titulaire: **THOMSON-CSF, 173, Boulevard Haussmann,
F-75379 Paris Cedex 08 (FR)**

(72) Inventeur: **Broussoux, Dominique, Thomson-CSF
SCPI 173, bld Haussmann, F-75360 Paris Cedex 08 (FR)**
Inventeur: **Facoetti, Hugues, Thomson-CSF
SCPI 173, bld Haussmann, F-75360 Paris Cedex 08 (FR)**
Inventeur: **Micheron, François, Thomson-CSF
SCPI 173, bld Haussmann, F-75360 Paris Cedex 08 (FR)**

(74) Mandataire: **Wang, Pierre et al, THOMSON-CSF
SCPI 173, Bld Haussmann, F-75379 Paris Cedex 08 (FR)**

ACTORUM AG

# Procédé de fabrication de films polymères piézoélectriques

La présente invention se rapporte aux polymères piézoélectriques qui se présentent sous la forme de films simples ou multicouches. Les propriétés piézoélectriques se manifestent lorsque ces films sont placés entre deux électrodes et que l'on applique à ces électrodes une tension électrique. On observe alors des déformations selon la direction de la normale aux faces et selon deux directions contenues dans le plan tangent aux faces. Inversement, sous l'effet d'une contrainte mécanique, il se développe par effet piézoélectrique inverse une tension électrique proportionnelle à la contrainte. L'obtention des propriétés piézoélectriques découle de l'existence d'une orientation dipolaire permanente qui n'existe pas lorsque le matériau cristallise à partir de l'état fondu. En effet, à ce stade le matériau polymère est dans une phase $\alpha$ non polaire.

Parmi les matériaux polymères susceptibles d'acquérir des propriétés piézoélectriques, on peut citer les polymères tels que le Chlorure de polyvinyle PVC, le Polyfluorure de vinyle PVF, le Polyfluorure de vinylidène $PVF_2$ et ses copolymères avec le Polytétrafluorure d'éthylène PTFE, le Polytrifluorure d'éthylène $PT_rFE$, le Polyfluorure de vinyle PVF et les mélanges faisant intervenir le Polyméthacrylate de méthyle PMMA.

Il est connu d'appliquer à ces matériaux et en particulier au Polyfluorure de vinylidène $PVF_2$ deux traitements successifs qui consistent à exercer une traction pour obtenir des allongements irréversibles pouvant atteindre 300 à 500%, ce qui transforme en phase polarisable la phase initiale et à orienter cette phase sous l'action d'un champ électrique intense proche de la limite de rigidité diélectrique du film.

Les opérations de fabrication classiques sont en général effectuées successivement et indépendamment, à savoir: formation par fusion de granulés et refroidissement sous presse d'une ébauche en forme de plaque, étirement mécanique de cette ébauche entre les machoires d'une machine de traction et polarisation du film étiré par application de tension électrique entre électrodes déposées sur le film ou par décharge Corona.

En ce qui concerne l'étirement du film, on peut envisager un traitement en continu qui consiste à enrouler le film provenant d'une bobine débitrice sur une bobine réceptrice animée d'un mouvement de rotation plus rapide. Compte tenu des forces mises en jeu, on conçoit aisément que cette technique ne s'applique qu'à des films minces n'excédant pas 50 microns d'épaisseur et à la condition de porter ces films à des températures supérieures ou égales au seuil de thermoplasticité.

En ce qui concerne la polarisation en continu, on peut faire circuler le film préalablement étiré entre une bobine débitrice et une bobine réceptrice tournant à la même vitesse. L'application d'une décharge Corona au film déroulé permet de ne pas appliquer de métallisation sur l'une au moins des faces du film. On peut aussi éviter de métalliser le film étiré en le faisant passer entre deux électrodes fixes ou deux rouleaux conducteurs. Aucune de ces techniques de polarisation n'est pleinement satisfaisante, car les champs électriques nécessaires pour obtenir des coefficients piézoélectriques satisfaisants sont trop proches des champs de claquage. Il faut choisir une température de polarisation suffisante pour que la mobilité d'orientation dipolaire puisse se manifester, ce qui conduit à une température d'au moins 80°C dans le cas du Polyfluorure de vinylidène. A cette température, la conductivité ionique abaisse le seuil de claquage diélectrique, de sorte que le champ électrique applicable en pratique résulte d'un compromis. A défaut de réaliser une orientation dipolaire complète, les coefficients piézoélectriques obtenus de façon reproductible sont pour $d_{33}$ inférieurs à 18 pc $N^{-1}$ et en augmentant le champ avec risque de claquage, inférieurs à 22 pc $N^{-1}$. D'après ce qui précède, on voit qu'une demande importante s'exerce dans le sens d'un procédé de fabrication en continu doté d'un taux de reproductibilité voisin de l'unité qui permette de traiter des films d'épaisseurs aussi grandes que le millimètre et qui produise des films orientés dont les coefficients piézoélectriques excèdent les valeurs obtenues jusqu'ici.

La présente invention repose sur deux constatations importantes qui sont que la technique du laminage permet d'étirer des films très épais à des températures voisines de la température ambiante et que dans le cas du Polyfluorure de vinylidène l'étirement à basse température favorise la transition de la phase non-polaire $\alpha$ vers la phase polaire $\beta$. On peut ajouter que les champs électriques de polarisation peuvent être notablement abaissés, lorsque préalablement les films sont cristallisés sous pression uniaxiale, car les axes cristallins a et b perpendiculaires à la direction des chaines macromoléculaires sont déjà partiellement orientés par rapport au plan du film.

L'invention a pour objet un procédé de fabrication en continu de film polymère piézoélectrique par étirement mécanique et polarisation électrique, caractérisé en ce qu'il consiste à former une ébauche de matériau polymère épousant la forme d'une galette d'épaisseur supérieure à celle dudit film et à étirer cette ébauche par laminage sous champ électrique de manière que ledit champ électrique est établi dans la zone d'écrasement sous forte pression de l'ébauche, pression suffisante pour provoquer une fusion partielle et une recristallisation dudit film; la température de laminage étant choisie dans une plage de basses températures s'étendant entre la température ambiante et le seuil de thermoplasticité du polymère constituant ledit film.

L'invention sera mieux comprise au moyen de la description ci-après et des figures annexées parmi lesquelles:

La figure 1 est une vue isométrique d'un dispositif de laminage destiné à la mise en oeuvre du procédé de fabrication selon l'invention.

La figure 2 est une vue éclatée d'une ébauche destinée au colaminage de deux films polymères.

La figure 3 est une figure explicative se rapportant au colaminage de l'ébauche de la figure 2.

La figure 4 est un diagramme explicatif.

La figure 5 illustre un agencement permettant d'obtenir une orientation dipolaire à composante parallèle aux faces des films colaminés.

La figure 6 illustre le colaminage d'une ébauche stratifiée comportant trois films polymères.

La figure 7 est une variante de réalisation de l'ébauche de la figure 6.

La transformation de films piézoélectriques dont il va être question intéresse un grand nombre de matériaux polymères, copolymères ou mélanges parmi lesquels figurent ceux qui ont déjà été mentionnés. Une référence est faite plus particulièrement au Polyfluorure de vinylidène, car il se prête à l'obtention de propriétés piézoélectriques relativement marquées. La structure de ce matériau se compose d'amas cristallins sphéroïdaux contenus dans une phase amorphe. Les propriétés mécaniques macroscopiques sont celles d'un corps isotrope. On distingue trois formes cristallines. La phase $\alpha$ est celle que l'on obtient à partir du polymère fondu; les chaines macromoléculaires sont enroulées en hélice et l'agencement des atomes de carbone, d'hydrogène et de fluor est tel que les moments électriques dipolaires se compensent l'un l'autre lorsqu'on progresse le long de la chaine. Les deux autres phases $\beta$ et $\mu$ sont moins stables que la phase $\alpha$. La phase $\beta$ peut être induite par étirement du matériau, car les chaines prennent une configuration en zig zag permettant aux moments dipolaires électriques d'ajouter leurs effets. La phase est une phase polaire susceptible d'être orientée électriquement.

En procédant à un étirement unidirectionnel suivi d'une polarisation en phase polaire, des propriétés piézoélectriques sont développées de façon permanente. Le tenseur de rang trois $d_{ijk}$ permet de représenter ces propriétés piézoélectriques comme suit:

$$d_{ijk} = \begin{vmatrix} 0 & 0 & 0 & 0 & d_{15} & 0 \\ 0 & 0 & 0 & d_{24} & 0 & 0 \\ d_{31} & d_{32} & d_{33} & 0 & 0 & 0 \end{vmatrix}$$

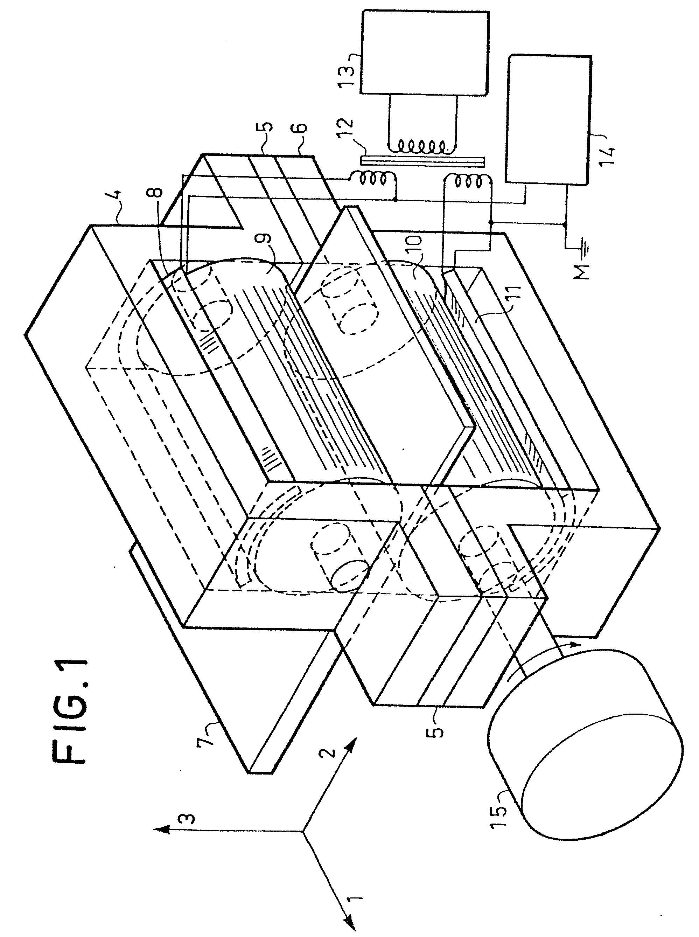

Sur la figure 1, on a représenté une ébauche de polymère 7 en cours de laminage et un système d'axes 1,2,3. L'ébauche 7 est une galette dont les faces principales sont perpendiculaires à l'axe 3. Le laminage provoque un étirement unidirectionnel selon l'axe 2 qui résulte de l'amincissement de l'ébauche 7. Les coefficients piézoélectriques $d_{31}$, $d_{32}$ et $d_{33}$ se rapportent au système d'axes 1, 2, 3 et se mesurent en picocoulomb par newton. Les coefficients $d_{31}$ et $d_{32}$ ont des valeurs inégales pour un étirement unidirectionnel.

Avant d'aborder la description détaillée de la figure 1, il est utile d'indiquer comment l'ébauche 7 peut être préparée en vue du traitement par laminag. On peut se servir d'une presse dont les plateaux plans permettent de porter à la fusion des granulés de polyfluorure de vinylidène de masse moléculaire moyenne M = 80 000. Une galette est formée à une température de 220°C. A titre d'exemple non limitatif, pour former une galette de 220 cm² de surface et d'une épaisseur de 0,7 mm, on exerce une poussée de 20 tonnes et le pressage dure une quinzaine de minutes. Le film solidifié est sorti de la presse et trempé dans l'eau pour limiter la croissance des amas cristallins. L'ébauche obtenue est prête à être laminée pour y développer les effets piézoélectriques.

Selon un premier aspect de l'invention, l'ébauche 7 est étirée par laminage sous champ électrique. A cet effet, on utilise une cage de laminoir en deux parties. La partie inférieure comprend par exemple un cylindre d'acier 10 monté dans un berceau métallique 6 de grande rigidité. L'axe du cylindre 10 est entrainé par un ensemble motoréducteur 15 permettant par exemple d'obtenir une vitesse d'avance de l'ébauche 7 de l'ordre de 0,09 mm/s. Pour un laminage à la température de 60°C, la force tangentielle appliquée aux cylindres de laminage est d'environ 50 tonnes ce qui conduit à un taux d'étirement de 3,8.

La partie supérieure de la cage de laminage comporte un second cylindre en acier 9 monté dans un berceau métallique 4. Une semelle isolante 5 est intercalée de chaque côté de la cage de laminage entre les deux berceaux 4 et 5 qui sont réunis par des boulons isolés électriquement que l'on n'a pas fait figurer sur la figure 1. Le cylindre supérieur 9 peut, le cas échéant, être entrainé par un accouplement isolant le reliant au groupe motoréducteur 15. Cet accouplement n'est pas non plus illustré sur la figure 1 par soucis de clarté.

Des radiateurs électriques à convexion 8 et 11 sont montés à proximité des cylindres 9 et 10 pour assurer leur chauffage. Ces radiateurs 8 et 11 sont alimentés par une source alternative 13 via un transformateur 12 à secondaires isolés. Les deux radiateurs 8 et 11 sont reliés électriquement aux deux berceaux 4 et 6 et à une source de polarisation 14 délivrant une haute tension continue. L'une des bornes de la source 14 est mise à la masse M.

Compte-tenu de la valeur de la tension de polarisation et de l'écartement des cylindres 9 et 10, le champ électrique qui s'établit dans la zone d'écrasement de l'ébauche 7 est de l'ordre de 550 kV/cm. Cette valeur qui ne dépasse pas le tiers du champ de claquage de la partie pincée de l'ébauche 7 permet d'obtenir après laminage un coefficient piézoélectrique $d_{33}$ de 28 pC.N⁻¹. En portant le champ électrique de polarisation à 750 kV/cm, on obtient la valeur $d_{33}$=32 pC.N⁻¹. ·

On peut attribuer ces valeurs piézoélectriques très élevées à un effet d'ultraorientation lié aux circonstances exceptionnelles que réunit le procédé de laminage sous champ.

En effet, trois éléments coopèrent simultanément:

- le film étant initialement en phase non-polaire, l'étirement possible à basse température convertit efficacement cette phase en phase polaire; l'axe des chaines est parallèle à la direction d'étirement.

- cette transition sous forte pression tend à orienter les axes a et b des amas cristallins par rapport aux faces principales du film laminé.

- cette transition du fait des fortes pressions mises en jeu s'accompagne d'une fusion partielle et d'une recristallisation. Les mesures faites avant et après laminage révèlent que la cristallinité a augmenté.

Le fait de mettre en jeu une fusion à basse température permet d'obtenir une très grande mobilité d'orientation dipolaire non accompagnée d'une élévation de conductivité ionique. Ainsi, l'application d'un champ électrique pendant le laminage et dans la zone qui se transforme conduit à un taux d'orientation dipolaire élevé auquel correspond une activité piézoélectrique élevée, avec un risque négligeable de claquage diélectrique.

Le laminage simple tel qu'illustré par la figure 1 peut se transformer en colaminage si l'on superpose plusieurs ébauches 7. Les orientations dipolaires sont selon l'axe 3 et de même sens.

On peut également réaliser un colaminage avec des orientations dipolaires en sens contraires sans avoir à isoler électriquement les deux cylindres de laminage.

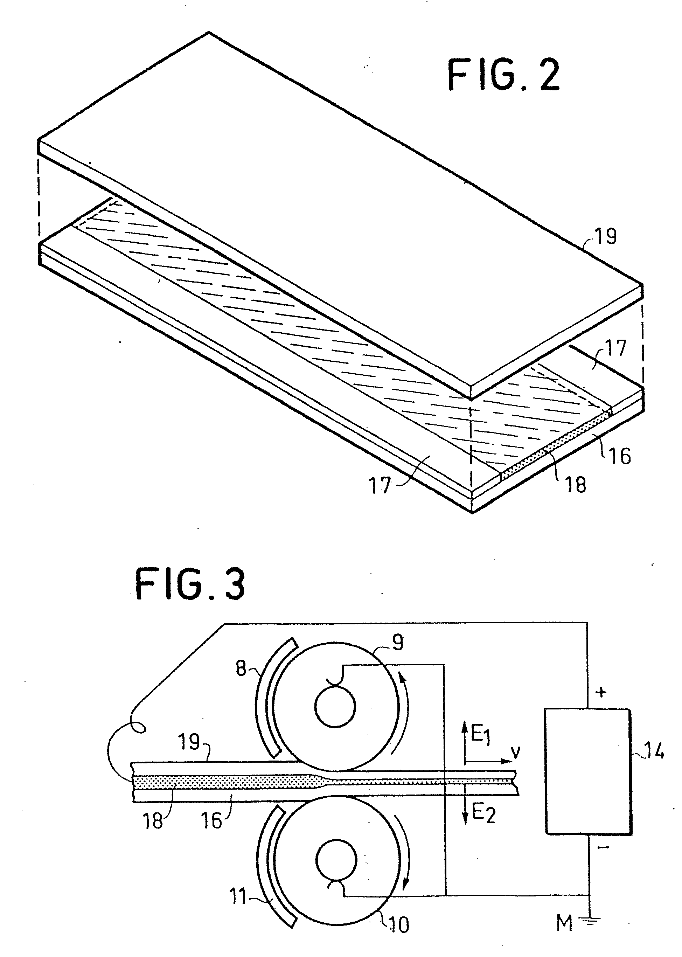

Sur la figure 2, on peut voir une vue éclatée d'une ébauche composite. Cette ébauche comporte deux plaques de polymère 16 et 19. La plaque supérieure 19 repose sur la plaque 16 via deux entretoises 17 qui encadrent une électrode centrale 18 liquide ou pâteuse. Les entretoises 17 peuvent être constituées par des rubans adhésifs qui s'opposent à tout débordement latéral du fluide de l'électrode 18. En cours de laminage, l'électrode intermédiaire 18 subit une déformation par allongement qui peut atteindre 400%. Pour confectionner l'électrode intermédiaire 18, on ne peut pas utiliser des films minces d'aluminium ou des couches métalliques évaporées, car celles-ci ne peuvent pas subir à froid un étirement aussi important. Néanmoins, on peut mettre en oeuvre par coulage des couches minces de métaux à bas point de fusion tels que le plomb ou le métal de Wood. Une solution préférable consiste à faire appel à des conducteurs fluides. A cet effet, on peut réaliser l'électrode 18 sous la forme d'un gel rendu conducteur à l'aide d'un sel ou d'un acide. Des graisses chargées de particules conductrices d'argent ou de noir de carbone conviennent également. Comme il s'agit d'une polarisation électrique portant sur des matériaux diélectriques, il suffit que les électrodes présentent une faible conductivité. Les rubans isolants 17 préviennent tout débordement intempestif de l'électrode fluide 18 qui pourrait entrainer un court-circuit ou une disrupture entre cette électrode et les cylindres de laminage. Le schéma de la figure 3 montre le raccordement électrique du générateur de polarisation 14. Les deux cylindres de laminage 9 et 10 sont reliés à la borne de masse M qui est commune à l'une des bornes du générateur 14. L'autre borne du générateur 14 est reliée par une connexion souple à l'électrode 18. Le sens de laminage est représenté par la flèche v; il est parallèle aux rubans délimitateurs 17. Avec les polarités indiquées sur la figure 3, les champs électriques polariseurs $E_1$ et $E_2$ sont de sens contraires et dirigés vers l'extérieur par rapport aux fibres 16 et 19.

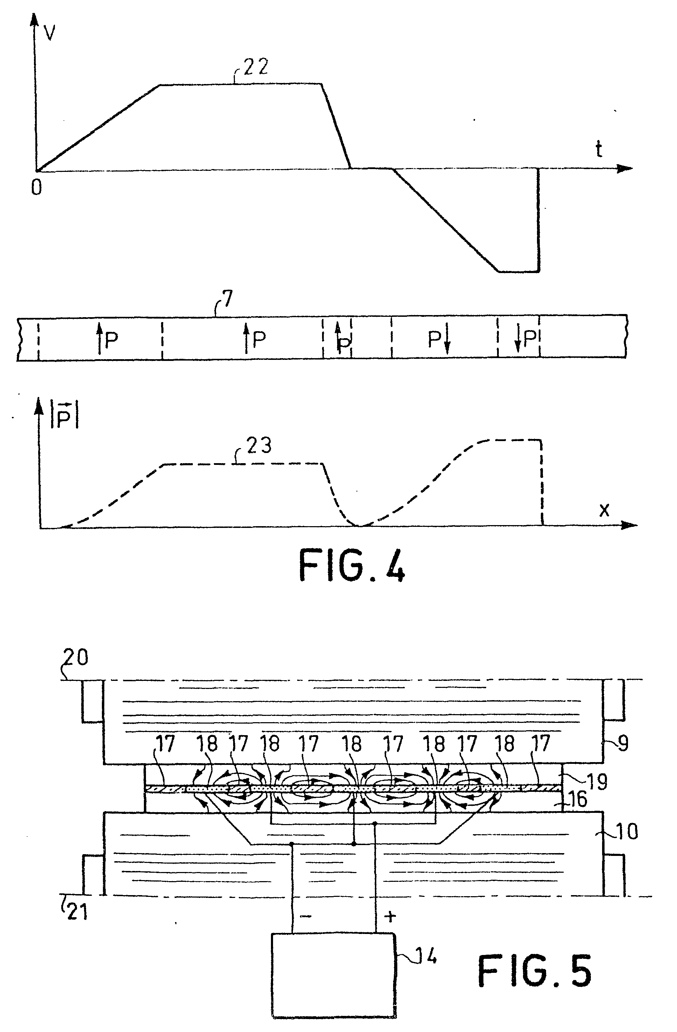

Avec les dispositifs de laminage et les ébauches représentés aux figures 1 à 3, on réalise une polarisation P de type transversal puisque le champ électrique est orienté normalement par rapport aux faces principales du film étiré. Les diagrammes de la figure 4 montrent que l'on peut faire varier la polarisation P du film étiré 7 en grandeur et en signe. Pour obtenir une variation d'intensité de polarisation dans le sens du laminage x telle que représentée par la courbe 23, on applique une tension de polarisation V qui évolue dans le temps comme le montre la courbe 22. Pour inverser le sens de la polarisation, il suffit d'inverser le signe de la tension V. Dans le cas des figures 2 et 3, l'étendue de la zone polarisée électriquement et rendue piézoélectrique est déterminée par l'étendue de l'électrode intermédiaire 18. On peut donc faire varier cette étendue par une délimitation appropriée de l'électrode 18. On peut également subdiviser l'électrode 18 en plusieurs îlots reliés à des générateurs de polarisation indépendants. Un pontage de tels îlots dans le sens du laminage assure la continuité électrique. Le dosage en grandeur, en signe et en étendue de la polarisation rémanente peut donc revêtir des formes extrêmement variées.

En outre, les deux films colaminés peuvent être de même nature ou de natures différentes. Ainsi, on peut colaminer un film de polyfluorure de vinylidène avec un film de polyéthylène. Le film de polyéthylène n'acquiert pas de propriétés piézoélectriques, mais il sert d'isolateur électrique, ce qui permet d'utiliser une laminoir de type courant.

Sur la figure 5, on a représenté partiellement deux cylindres de laminage 9 et 10 d'axes de rotation 20 et 21. L'ébauche laminée entre ces cylindres diffère de celle de la figure 2 par le fait que l'électrode fluide 18 est subdivisée et occupe plusieurs compartiments délimités par des entretoises 17. La polarisation électrique n'est pas directement appliquée entre l'électrode 18 et les cylindres 9 et 10. En allant de gauche à droite, on voit sur la figure 5 que les électrodes élémentaires 18 sont alternativement raccordées aux deux pôles de la source de polarisation 14. Il en résulte que le champ électrique dans les films 16 et 19 possède une composante parallèle aux faces principales au droit de chaque cloison isolante 17. Il est donc possible d'obtenir une orientation dipolaire parallèlement aux axes 20 et 21.

L'invention n'est nullement limitée au colaminage de deux films.

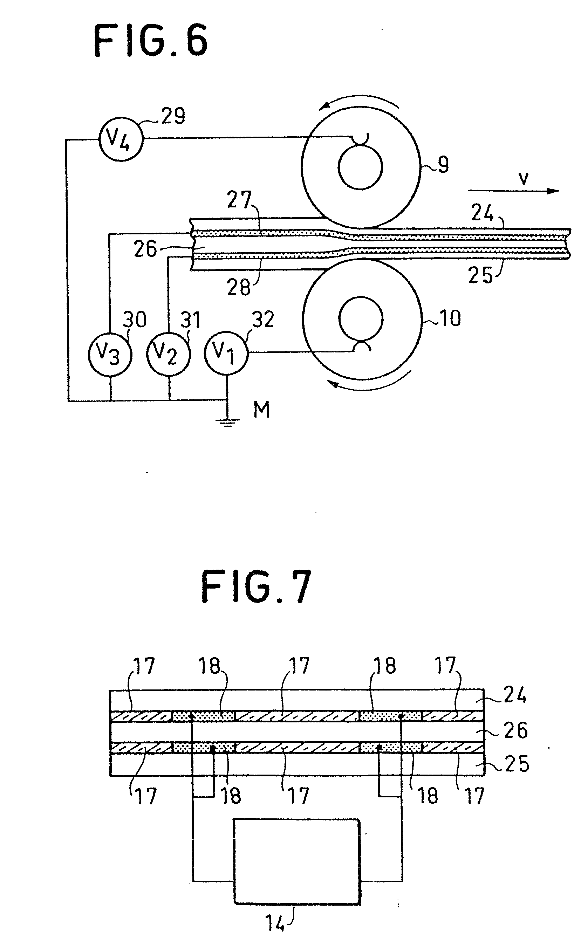

Sur la figure 6, on peut voir une ébauche formée en superposant trois films polymères 24, 26 et 25. Deux électrodes fluides intermédiaires 27 et 28 sont prévues pour séparer les films. Quatre générateurs de tension 29, 30, 31 et 32 peuvent être utilisés pour fixer les potentiels $V_4$, $V_3$, $V_2$ et $V_1$ appliqués aux cylindres 9 et 10 et aux électrodes 27 et 28. Le film 24 est soumis à la tension $V_4 - V_3$; le film 26 est soumis à la tension $V_3 - V_2$ et le film 25 est soumis à la tension $V_2 - V_1$.

Il est aisé de vérifier que l'un de ces générateurs est superflu lorsqu'on désire polariser de façon quelconque les trois films. Si les deux films extérieurs 24 et 25 ne sont pas à polariser, on peut se contenter d'un seul générateur relié aux électrodes 27 et 28. Les cylindre 9 peut alors être relié à l'électrode 27 et le cylindre 10 à l'électrode 28. Bien entendu, on peut faire varier les potentiels $V_1$, $V_2$, $V_3$ et $V_4$ pour obtenir une modulation de l'orientation dipolaire dans chacun des films.

Sur la figure 7, on peut voir une vue en coupe d'une ébauche du type tricouche dans laquelle les électrodes fluides 18 sont encadrées par des entretoises 17 qui épousent la forme de rubans alignés selon la direction de laminage (perpendiculaire au plan de la figure). Comme illustré sur la figure 7, les électrodes 18 sont raccordées au générateur électrique 14 de façon à créer dans les films 24, 26 et 25 un champ électrique à composante parallèle à l'axe des cylindres de laminage. Cette disposition permet de réduire l'influence perturbatrice des cylindres de laminage sur la répartition du champ électrique induit par les électrodes 18. Rien n'empêche de prévoir plus de deux rangées d'électrodes 18 pour créer d'autres distributions de champ électrique avec un ou plusieurs générateurs de polarisation.

Les films étirés et polarisés sont généralement séparables lorsqu'ils ont été colaminés. Cependant, on peut utiliser le colaminage de deux films identiques pour réaliser des structures piézoélectriques bimorphes. Dans ce cas, l'électrode intermédiaire 18 visible sur les figures 2 et 3 est constituée par une couche mince de colle conductive. La firme CHOMERICS produit sous la dénomination EPOTEX 58429 un adhésif époxy chargé à l'argent. Cet adhésif est déposé avant polymérisation entre les entretoises 17 par sérigraphie, coulage, peinture, pulvérisation, etc... Le colaminage et la polymérisation sont effectués immédiatement après le dépôt de la colle conductrice. Après laminage et polarisation, le bimorphe réalisé est maintenu à la température qui permet la polymérisation de la colle. Dans le cas de la colle EPOTEX 58429, il faut prévoir un temps de prise de 24 heures à la température ambiante ou 5 heures à 60°C. La température de polymérisation doit être inférieure à la température à partir de laquelle le polymère risque de se dépolariser. Pour le polyfluorure de vinylidène, la température de dépolarisation est de 100°C.

Pour terminer, il y a lieu de signaler que le procédé de fabrication est adaptable à une fabrication industrielle en continu. Les films constituant l'ébauche à laminer sous champ peuvent être obtenus dans la largeur du laminoir par extrusion. Le dépôt en continu d'une électrode fluide ne pose pas de difficulté.

D'autre part, le laminage peut se faire en deux passes successives lorsqu'on désire obtenir un matériau biétiré. Dans une première opération, l'ébauche par exemple carrée est laminée sous champ à 270% d'allongement pour obtenir une forme rectangulaire de largeur sensiblement inchangée. Cette forme est introduite à nouveau dans le laminoir par son grand côté pour une seconde passe de laminage sous champ. Le film biétiré obtenu a repris une forme carrée.

## Revendications

1. Procédé de fabrication en continu de film polymère piézoélectrique par étirement mécanique et polarisation électrique, caractérisé en ce qu'il consiste à former une ébauche (7) de matériau polymère épousant la forme d'une galette d'épaisseur supérieure à celle dudit film et à étirer cette ébauche par laminage sous champ électrique de manière que ledit champ électrique est établi dans la zone d'écrasement sous forte pression de l'ébauche, pression suffisante pour provoquer une fusion partielle et une recristallisation dudit film; la température de laminage étant choisie dans une plage de basses températures s'étendant entre la température ambiante et le seuil de thermo-plasticité du polymère constituant ledit film.

2. Procédé selon la revendication 1, caractérisé en ce que l'ébauche (7) comporte plusieurs films superposés (24, 25, 26); lesdits films étant colaminés.

3. Procédé selon la revendication 2, caractérisé en ce que l'ébauche (7) est munie d'au moins une électrode intermédiaire (18).

4. Procédé selon l'une quelconque des revendications 1 à 3, caractérisé en ce que l'opération de laminage est effectuée par deux cylindres conducteurs contrarotatifs (9, 10) entre lesquels est appliquée une tension de polarisation.

5. Procédé selon la revendication 3, caractérisé en ce que l'opération de laminage est effectuée par deux cylindres conducteurs contrarotatifs (9, 10); ladite polarisation électrique étant obtenue en reliant ladite électrode intermédiaire et lesdits cylindres à une source de tension électrique.

6. Procédé suivant la revendication 3, caractérisé en ce que l'opération de laminage est effectuée par deux cylindres contrarotatifs (9, 10); ladite polarisation étant obtenue en appliquant une tension électrique entre deux électrodes intermédiaires.

7. Procédé selon l'une quelconque des revendications 3, 5 et 6, caractérisé en ce que l'électrode intermédiaire (18) est une électrode fluide délimitée transversalement par rapport à la direction de laminage.

8. Procédé selon la revendication 7, caractérisé en ce que l'électrode fluide est constituée par une substance adhésive conductrice polymérisable.

9. Procédé selon l'une quelconque des revendications 7 et 8, caractérisé en ce que plusieurs électrodes fluides (18) sont déposées sur une même face dudit film (16) et sont isolées l'une de l'autre par des séparations diélectriques intercalaires (17) agencés en réseau sur ladite face.

10. Procédé selon l'une quelconque des revendications 1 à 9, caractérisé en ce que la polarisation électrique est modulée au cours du laminage.

11. Procédé selon l'une quelconque des revendications 2 et 8, caractérisé en ce que lesdits films sont identiques.

12. Procédé selon la revendication 2, caractérisé en ce que lesdits films comprennent au moins un film susceptible d'acquérir des propriétés piézoélectriques et au moins un film d'un autre matériau polymère.

13. Procédé selon l'une quelconque des revendications 1 à 12, caractérisé en ce que l'ébauche subit deux passes de laminage croisées.

14. Procédé selon la revendication 13, caractérisé en ce que le laminage comporte deux passes successives de directions perpendiculaires et produisant des étirements égaux.

## Ansprüche

1. Verfahren zur kontinuierlichen Herstellung eines piezoelektrischen polymeren Films durch mechanisches Ziehen und elektrische Polarisation, dadurch gekennzeichnet, dass es darin besteht, einen Rohling (7) aus Polymer-Material zu formen, der die Form einer Platte mit einer grösseren Dicke als der des Films annimmt, und diesen Rohling durch Auswalzen in einem elektrischen Feld in die Länge zu ziehen, so dass dieses elektrische Feld in der Zone herrscht, in der der Rohling unter starkem Druck gequetscht wird, wobei der Druck ausreicht, um eine teilweise Fusion und eine Rekristallisierung des Films hervorzurufen, und wobei die Walztemperatur in einem Bereich niedriger Temperaturen gewählt wird, der sich zwischen der Umgebungstemperatur und der Schwelle der Thermoplastizität des diesen Film bildenden Polymers erstreckt.

2. Verfahren nach Anspruch 1, dadurch gekennzeichnet, dass der Rohling (7) mehrere aufeinandergeschichtete Filme (24,25,26) aufweist, die gemeinsam gewalzt werden.

3. Verfahren nach Anspruch 2, dadurch gekennzeichnet, dass der Rohling (7) mit mindestens einer Zwischenelektrode (18) ausgerüstet ist.

4. Verfahren nach einem beliebigen der Ansprüche 1 bis 3, dadurch gekennzeichnet, dass der Auswalzvorgang durch zwei leitende, im Gegensinn drehende Zylinder (9, 10) durchgeführt wird, zwischen denen eine Polarisationsspannung angelegt wird.

5. Verfahren nach Anspruch 3, dadurch gekennzeichnet, dass der Auswalzvorgang von zwei leitenden im Gegensinn drehenden Zylindern (9, 10) durchgeführt wird, indem die Zwischenelektrode und die Zylinder an eine elektrische Spannungsquelle angeschlossen werden.

6. Verfahren nach Anspruch 3, dadurch gekennzeichnet, dass der Auswalzvorgang von zwei im Gegensinn drehenden Zylindern (9, 10) durchgeführt wird, wobei die Polarisation dadurch erhalten wird, dass eine elektrische Spannung zwischen zwei Zwischenelektroden angelegt wird.

7. Verfahren nach einem beliebigen der Ansprüche 3, 5 und 6, dadurch gekennzeichnet, dass die Zwischenelektrode (18) eine fliessfähige Elektrode ist, die quer zur Walzrichtung begrenzt ist.

8. Verfahren nach Anspruch 7, dadurch gekennzeichnet, dass die fliessfähige Elektrode aus einer leitenden haftenden polymerisierbaren Substanz besteht.

9. Verfahren nach einem beliebigen der Ansprüche 7 und 8, dadurch gekennzeichnet, dass mehrere fliessfähige Elektroden (18) auf eine gemeinsame Oberfläche des Films (16) aufgebracht werden und voneinander durch die dielektrische Zwischentrennwände (17) getrennt sind, die in Netzform auf dieser Oberfläche angeordnet sind.

10. Verfahren nach einem beliebigen der Ansprüche 1 bis 9, dadurch gekennzeichnet, dass die elektrische Polarisation während des Walzens moduliert wird.

11. Verfahren nach einem beliebigen der Ansprüche 2 und 8, dadurch gekennzeichnet, dass die Filme identisch sind.

12. Verfahren nach Anspruch 2, dadurch gekennzeichnet, dass die Filme mindestens einen Film aufweisen, der piezoelektrische Eigenschaften annehmen kann, und mindestens einen Film aus einem anderen Polymermaterial.

13. Verfahren nach einem beliebigen der Ansprüche 1 bis 12, dadurch gekennzeichnet, dass der Rohling zwei Wahlzvorgängen in gekreuzten Richtungen unterworfen wird.

14. Verfahren nach Anspruch 13, dadurch gekennzeichnet, dass das Walzen aufeinanderfolgend zwei Durchgänge in senkrecht zueinander liegenden Richtungen umfasst, die gleiche Längungen bewirken.

## Claims

1. A method for continuously manufacturing a piezoelectric polymer film by mechanical stretching and electrical polarisation, characterized in that it consists in forming a raw piece of polymer material which adapts the form of a plate with a layer thickness higher than that of said film, and in stretching said raw piece means of a lamination process under an electrical field so that said electrical field is established in the crush zone of the raw piece under strong pressure, which is sufficient to provoke a partial fusion and a recristallization of said film; the lamination temperature being chosen in a range of low temperatures extending from the ambient temperature to the threshold of thermo-plasticity of the polymer which constitutes the film.

2. A method according to claim 1, characterized in that the raw piece (7) comprises several superposed films (24, 25, 26), said films being co-laminated.

3. A method according to claim 2, characterized in that the raw piece (7) is furnished with at least one intermediate electrode (18).

4. A method according to any one of the claims 1 to 3, characterized in that the lamination step is carried out by means of two conductive counterrotating cylinders (9, 10) between which a polarisation voltage is applied.

5. A method according to claim 3, characterized in that the lamination step is carried out by means of two conductive counterrotating cylinders (9, 10), said electrical polarisation being obtained by connecting said intermediate electrode and said cylinders to a source of electrical voltage.

6. A method according to claim 3, characterized in that the lamination step is carried out by means of two counterrotating cylinders (9, 10), said polarisation being obtained by applying an electrical voltage between two intermediate electrodes.

7. A method according to any one of the claims 3, 5 and 6, characterized in that the intermediate electrode (18) is a fluid electrode which is limited transversely with respect to the lamination direction.

8. A method according to claim 7, characterized in that the fluid electrode is constituted by an adhesive conductive substance which is able to polymerize.

9. A method according to any one of the claims 7 and 8, characterized in that several fluid electrodes (18) are deposited on the same face of said film (16) and are isolated from each other by dielectrical separator means (17) arranged in a net shape on said face.

10. A method according to any one of the claims 1 to 9, characterized in that the electrical polarisation is modulated during the lamination step.

11. A method according to any one of the claims 2 and 8, characterized in that said films are identical.

12. A method according to claim 2, characterized in that said films comprise at least a film apt to acquire piezoelectrical properties and at least one film of another polymer material.

13. A method according to any one of the claims 1 to 12, characterized in that the raw piece undergoes two crossed lamination passages.

14. A method according to claim 13, characterized in that the lamination step comprises two successive passages of perpendicular directions and producing equal stretching rates.

FIG.1

0 048 642

0 048 642

# FIG. 2

# FIG. 3

FIG. 4

FIG. 5

# FIG.6

# FIG.7